(19) Europäisches Patentamt
European Patent Office
Office européen des brevets

(11) **EP 2 280 469 B1**

(12) **EUROPEAN PATENT SPECIFICATION**

(45) Date of publication and mention
of the grant of the patent:
**06.07.2016 Bulletin 2016/27**

(51) Int Cl.:
*H02J 7/35* *(2006.01)*      *H01L 31/02* *(2006.01)*

(21) Application number: **09166852.5**

(22) Date of filing: **30.07.2009**

(54) **A photovoltaic unit, a dc-dc converter therefor, and a method of operating the same**

Photovoltaische Einheit, Gleichstromwandler dafür und Verfahren zu deren Betrieb

Unité photovoltaïque, son convertisseur cc/cc, et son procédé de fonctionnement

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**02.02.2011 Bulletin 2011/05**

(73) Proprietor: **NXP B.V.**
**5656 AG Eindhoven (NL)**

(72) Inventors:
• **Buthker, Henricus Cornelis Johannes**
  **Redhill, Surrey RH1 1DL (GB)**
• **De Waal, Klaas**
  **Redhill, Surrey RH1 1DL (GB)**
• **Bergveld, Hendrik Johannes**
  **Redhill, RH1 1DL (GB)**

• **Hoogzaad, Gian**
  **Redhill, Surrey RH1 1DL (GB)**
• **Schoofs, Franciscus**
  **Redhill, Surrey RH1 1DL (GB)**

(74) Representative: **Hardingham, Christopher Mark**
**NXP B.V.**
**Intellectual Property & Licensing**
**Red Central**
**60 High Street**
**Redhill, Surrey RH1 1SH (GB)**

(56) References cited:
**EP-A- 1 081 824       EP-A- 1 662 644
WO-A-03/098703        WO-A-2009/028579
DE-A1- 10 219 956      US-A- 5 631 534
US-A1- 2005 139 258**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field of the Invention

This invention relates to photovoltaic units and to methods of operating photovoltaic units.

Background of the Invention

A photovoltaic cell (hereinafter also referred to as a solar cell) is a device which directly converts light such as sunlight into electricity. A typical such device is formed of a p-n junction in a semiconductor material. In operation, one surface of the device is exposed to light typically through an anti-reflective coating and protective material such as glass. Contact to this surface is made by a pattern of conductive fingers typically of a metal such as aluminium. Electrical contact to the other side of the p-n junction is typically provided by a continuous metal layer.

Photovoltaic (PV) systems, typically made of several hundreds of solar cells, are increasingly used to generate electrical energy from solar energy falling on solar modules, hereinafter also referred to as solar panels. Generally, each solar module is formed by placing a large number of solar cells in series. A PV system is then formed by placing a number of solar modules in series, to create a string and sometimes by placing multiple strings of in-series-connected solar modules in parallel, depending on the desired output voltage and power range of the PV system.

In practical cases, differences will exist between photogenerated currents, and output powers, of individual solar cells in the various modules, e.g. due to (part of) the modules being temporarily shaded, pollution on one or more solar cells, or even spread in solar cell behaviour - for instance due to manufacturing variations or to differences in the rate of degradation of performance of cells during aging. Due to the current-source type behaviour of solar cells and their series connection these differences can lead to a relatively large drop in output power coming from a PV system, as will be explained in more detail herebelow.

If one or more cells in a module produce a lower photo-venerated current than the remaining cells, for instance due to partial shading, the current-matching constraint resulting from the series connection of the cells can force these lower current cells into reverse bias until their respective diode reaches reverse breakdown. This can result in significant reverse bias being developed across the cell (or cells), and potentially damaging power dissipation in the shaded cells. In order to limit this power dissipation, it is well-known to include a bypass diode across a group, also hereinafter referred to as segment, of cells.

Whether or not a bypass diode is used across the segment, partial shadowing to even, one or two cells can severely restrict, or even prevent, the whole segment from contributing power to the overall system.

Applicant's co-pending International Patent Application IB2009/053001 (attorney docket: 81382083), which is not pre-published, discloses an arrangement wherein a photovoltaic unit, comprising a plurality of series-connected segments, is provided with one or more supplementary power units, each in parallel with a segment, the segment comprising a series-connected group of solar cells. The supplementary power unit is operable to provide additional current in parallel with cells of a segment which has lower current (at its optimum - "maximum power" operating point), than other series-connected segments. The loss in power attributable to a segment having one or more partially shaded cells, can thereby be significantly reduced.

The supplementary power units of IB2009/053001 are preferably configured as DC-DC converters, the input power for which is provided from the series-connected string of segments. However, in such an arrangement a high voltage connection (having the full string voltage) is required for each DC-DC converter, or alternatively, an intermediate converter is required to reduce the voltage to a level closer to that of each segment, along with voltage isolators, to allow level shifting of the voltage. Provision of either high-voltage converters or the additional intermediate converter is undesirable, as it results in additional costs to the system.

DE 102 19 956 discloses a solar system in which a half bridge DC/DC converter ("balance transducer 14") is arranged connected across two neighbouring solar units with a connection therebetween, and configured to maximise the output power from the two neighbouring modules by means of a controlling the voltage across them to a predetermined ratio. US 2005/1392658 (D2) discloses a solar cell array control device, which comprises a bidirectional DC-DC flyback converter. EP 1081 824 (D3) discloses a method and apparatus for equalising voltages over capacitors in a series connection capacitors during charging and discharging.

There thus remains a need for a photovoltaic unit which reduces or eliminates power wastage arising from shadowing but does not require a high voltage. DC-DC converter, or voltage-isolated converters.

Summary of the invention

The present invention relates to a photovoltaic unit according to claim 1.

It is an object of the present invention to provide a photovoltaic unit in which losses due to differential currents between individual cells or sub-units is reduced.

According to a first aspect of the present invention there is provided a photovoltaic unit comprising a plurality of sub-units connected in series, each sub-unit having a main input and a main output, which main output is connected to the respective main input of a neighbouring sub-unit each sub-unit further comprising a segment comprising one or more series-connected solar cells, and a supplementary power unit, wherein the supplementary power unit is configured to at least one of receive power from or supply power to the neighbouring sub-unit. Preferably, the supplementary power unit is configured to at least one of source current to and sink current from the main output of the respective sub-unit.

In embodiments, the supplementary power unit has a first pair of terminals and a second pair of terminals, the first pair of terminals being connected one to each of the main input of the respective sub-unit and the main output of the neighbouring sub-unit, and the second pair of terminals being connected one to each of the main input of the respective sub-unit and the main output of the respective sub-unit. It will be appreciated by the skilled person that the first pairs of terminal thus operate as input terminals and the second pair of terminals operate as output terminals, when the supplementary power unit is a down converter or a bi-directional converter operating as a down converter; conversely, the first pair of terminals operate as output terminals and the second pair of terminals operate as input terminals, when the supplementary power unit is an up converter or a bi-directional converter operating as an up converter.

In particularly preferred embodiments, the supplementary power unit comprises at least a DC-DC converter. Thus, the supplementary power unit may comprise more than one DC-DC converter; this may particularly be the case in embodiments in which each DC-DC converter is either an up converter or a down converter. Preferably, the DC-DC converter comprises two series-connected switches connected between the input terminals and having a half-bridge node therebetween, and an inductor connected between the half-bridge node and the main output of the respective sub-unit.

In embodiments, the photovoltaic unit further comprises a capacitor connected between the main input and the main output of the respective sub-unit. Absent some sort of smoothing reactive component such as a capacitor, there is likely to be too much voltage variation, resulting in losses since the segment may then at times operate significantly off its maximum power operating point

In embodiments, the supplementary power unit further comprises control means for controlling the series-connected switches. Preferably, the control means is configured to control the switches such that the supplementary power unit operates as a half-bridge converter. A half bridge converter is a particularly efficient converter to use for this application.

Preferably, the control means comprises a communication interface to the neighbouring sub-unit. In embodiments, the control means further comprises a level shifter. This can be useful in order to enable multiple controllers (one in each supplementary power unit) to be connected in series by means of the communication interface.

In embodiments the supplementary power unit comprises a capacitor, a first electrode of which is arranged to be switchably connectable to either the main input or the main output of the respective sub-unit, and a second electrode of which is arranged to be switchably connectable to either the main output of the respective sub-unit or the main output of the neighbouring sub-unit. The supplementary power unit may further comprise control means for controlling the switching of the capacitor. The supplementary power unit may then further comprise first, second, third and fourth switches, the photovoltaic unit further comprising control means operable to sequentially connect the capacitor across either the sub-unit or the neighbouring subunit by means of the first and second switches, and the third and fourth switches, respectively. The supplementary power unit can thus operate as a capacitive converter.

In embodiments, the supplementary power unit is disabled if the node between the sub-unit and the neighbouring sub-unit is within a predetermined voltage window around half the voltage between the input of the sub-unit and the output of the neighbouring sub-unit. Thus, bouncing between up-converter and down-converter modes may be avoided, and the power consumption involved in operating the supplementary power unit may be avoided, should this consumption be higher than the power gain achievable from nearly-matched modules. Furthermore, such a window may also be effective in allowing voltage variation between sub-units caused by temperature differences, rather than by insolation variation, without triggering operation of the supplementary power unit,

According to another aspect of the present invention, there is provided a DC-DC converter configured as the supplementary power unit for use in a photovoltaic unit as described above, and comprising a power interface for exchanging power with a neighbouring supplementary power unit and a communication interface for exchanging control information with a neighbouring supplementary power unit, wherein the power interface comprises the pair of output terminals arranged for connection to a pair of input terminals of a neighbouring supplementary power unit.

According to a yet further aspect of the present invention, there is provided a method of operating a photovoltaic unit comprising a plurality of sub-units, each sub-unit comprising a main input and a main output, which main output is connected to the respective main input of a neighbouring sub-unit, the sub-unit further comprising a segment comprising one or more series-connected solar cells, and a supplementary power unit, the method comprising determining a segment power generated by the sub-unit's segment, determining a neighbouring power generated by the segment of the neighbouring sub-unit, and operating the supplementary power unit to exchange power between the sub-unit and the respective neighbouring sub-unit in dependence on the difference between the segment power and the neighbouring power.

These and other aspects of the invention will be apparent from, and elucidated with reference to, the embodiments described hereinafter.

## Brief description of Drawings

Embodiments of the invention will be described, by way of example only, with reference to the drawings, in which

Figure 1 illustrates, at 1 (a)) a single-diode model of a photovoltaic device, at 1(b) the operating characteristic of a photovoltaic device, both in the dark and illuminated, at 1 (c) part of the operating characteristic in more detail, and at 1(d) graphs showing the influence of illumination level of the operating characteristic;

Figure 2 shows operating characteristics of multiple solar cells connected in series;

Figure 3 shows in schematic form the layout of a typical photovoltaic module;

Figure 4 shows photovoltaic modules having shadows thereon;

Figure 5 shows a pair of series connected solar cells having current sources connected in parallel thereto;

Figure 6 shows, in schematic form, a string of sub units, each sub unit comprising a segment of series-connected solar cells and a DCDC converter;

Figure 7 shows the series connected solar cells of figure 5, but having an energy storage element connectable in parallel thereto according to embodiments of the invention;

Figure 8 shows a pair of series-connected segments having a DC-DC converter connected thereto;

Figure 9 shows a more detailed version of figure 8, including a controller, as part of the DC-DC converter;

Figure 10 shows the IV and PV operating characteristics of fully illuminated and partially shaded segments, when operated according to the schema of figure 9;

Figure 11 shows simulations of operating characteristics of a fully illuminated, and partially shaded segment at 11a and 11 b respectively;

Figure 12 shows simulations of IV and PV characteristics of a series-connection of the modules of figure 11, at 12(a) without any delta converter, and at 12b with a delta converter in operation;

Figure 13 shows a module of three series-connected segments with two DC-DC converters connected thereto;

Figure 14 shows a photovoltaic unit comprising two modules as shown in figure 13, and including additional converters arranged to connect the modules;

Figure 15 shows the operation of a simplified exemplary module including DC-DC converters;

Figure 16 shows a pair of segments with a DC-DC converter including temperature sensing;

Figure 17 shows schematically a capacitive based for energy exchange between neighbouring segments; and

Figure 18 shows schematically an implementation of a capacitive energy exchange between two segments,

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

## Detailed description of embodiments

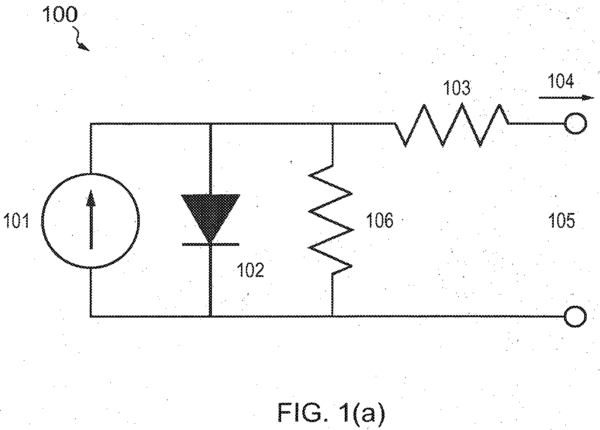

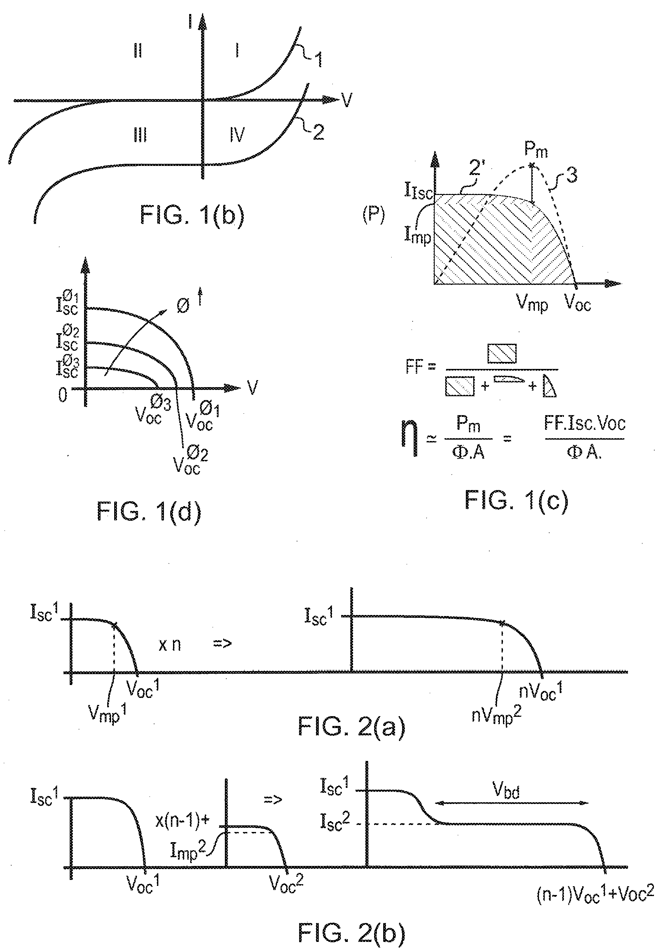

Figure 1 shows the equivalent circuit 100 which is most often used to model the performance of a solar cell (the so-called single-diode model). A current source 101 corresponding to the photo-generafied current (also referred to hereinafter as insolation current) $I_{ins}$ is in parallel with a diode 102 and shunt (that is, parallel) resistance Rp at 106. That part of $I_{ins}$ which does not flow through the diode or shunt resistance flows to an output node via the low-ohmic series resistance Rs 103 (typically a few m$\Omega$ per cell). Some internal leakage occurs via the high-ohmic shunt resistance Rp (typically in a k$\Omega$ to M$\Omega$ range).

Its accompanying I-V characteristic is shown in Fig. 1b, for the case where the photo-generated current $I_{ins}$ is zero (curve 1) corresponding to no irradiation, and non-zero (curve 2) corresponding to an irradiated cell. As shown in the un-irradiated case, the IV characteristic is that of a diode with shunt and series resistances, and lies in the first and third quadrants of the IV plane; introduction of irradiation due to e.g. insolation translates the IV characteristic downwards, into the IV (that is, fourth) quadrant of the IV plane. Normally, the (IV-quadrant) part of the characteristic which is of most interest in photovoltaics is shown inverted, as can be seen on Figure 1(c) at 2' along with the corresponding power-voltage (P-V) curve 3.

When the cell is shorted, an output current I of a cell equals the value of the current source ($I_{ins}$=short-circuit current Isc in the I-V characteristic in Fig. 1c), less current though the shunt resistance 106 - which is usually negligible. Basically, the output current is linearly proportional to the amount of incoming light for light conditions exceeding 100 W/m$^2$, which is typical for most cases during outdoor use. When left open-circuit, current $I_{ins}$ will flow mostly into the diode leading to an open-circuit voltage Voc, which for a polycrystalline silicon cell may typically be roughly 0.6 V, see Fig. 1c.

As can be seen, there is a single point on the IV curve which produces maximum power (at the voltage corresponding to the maximum power peak Pm of the P-V curve). In the Figure are shown short-circuit current Isc and open-circuit voltage Voc, along with the current (Imp) and voltage (Vmp) at the maximum power point (MPP). Thus Pm = Imp * Vmp, and is related to the product of Isc and Voc by means of the fill factor FF: Pm = Isc * Voc * FF. Figure 1(c) also shows the conversion efficiency $\eta$, and the relation between efficiency and irradiance $\Phi$.

Figure 1 (d) shows the change (in the IV-quadrant) of the IV characteristic with varying irradiance $\Phi$. The short-circuit current Isc scales linearly with increasing illumination $\Phi$ as shown at Isc $\varphi 1$, Isc $\varphi 2$ and Isc $\varphi 3$. The open-circuit voltage Voc increases slowly with increasing irradiance $\Phi$, as shown at Voc $\varphi 1$, Voc $\varphi 2$ and Voc $\varphi 3$.

Since a cell's output current depends e.g. on the amount of incoming light (insolation) and further cell behaviour is also temperature dependent, as a consequence the current and voltage value at which maximum power is obtained from a cell varies with environmental conditions. Therefore, in order to obtain a maximum output, in any practical solar system preferably this maximum power point needs to be continuously updated, which is referred to as Maximum-Power-Point Tracking (MPPT). In a sub-optimal configuration this is usually performed for all solar cells simultaneously.

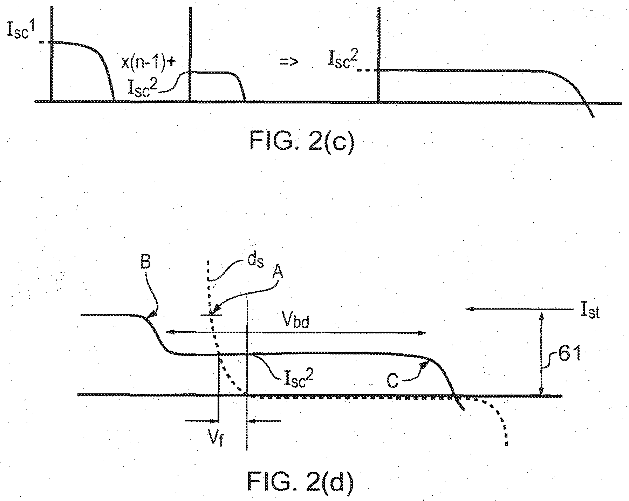

As already mentioned, in order to provide useful power, in most applications solar cells are connected in series, in a module or sub-unit. The possible resulting IV characteristics are illustrated schematically in Figure 2. Since the cells are series connected, the current through each cell must be the same. Figure 2(a) shows the situation where each cell has the same characteristic, under the same illumination conditions. Then, the module IV characteristic is simply a stretched (in the voltage direction) version of the individual cell characteristic: If each cell has short-circuit current, open-circuit voltage, max power voltage and max power of, respectively, Isc1, Voc1, Vmp1 and Pmax1, then the module has respective short-circuit current, open-circuit voltage, max power voltage and max power of Isc1, n*Voc1, n*Vmp1 and n*Pmax1.

However, if one of the cells has a lower short-circuit current Isc2 (and open-circuit voltage Voc2), as shown schematically, and slightly simplified, in Figure 2(b), then when the other cells are producing current Isc1, that cell will be driven into reverse bias until it starts to break down, (with a reverse bias of Vbd). The current-matching constraint results in an IV characteristic with a further "knee", which lies to the left of the original max-power knee, by a voltage of Vbd. To the left of this further knee, the characteristic slopes up to Isc1 with a slope dependant on the reverse breakdown of the lower current cell; between this knee and the original Vmp (ie n*Vmp1), the current is Isc2. The module open-circuit voltage is (n-1)*Voc1 + Voc2, which is approximately n*Voc1, and the right-hand max power point is still approximately at n*Vmp1.

As shown, the lower current cell starts to reverse breakdown with a sufficiently low Vbd, that the further "knee" is to the right of the axis. However, where the cell has a high Vbd, the knee could be to the left of the axis - and thus does not form part of the IV-quadrant characteristic. This is shown schematically in Figure 2(c).

In practice, many reasons exist why an output current of one cell will not be equal to that of another. Examples are shading, local contaminations on a module (e.g. bird droppings, leafs, etc), and spread between cells (aggravated by aging). The most prominent is that of (partial) shading, where one or more cells in one or several modules receive less incoming light than others, leading to lower $I_{ins}$ values than that, of other cells. In practice, shading of a cell may lead to 40-70% less incoming light than cells that have no shadow across them. In practical systems, partial shading may only occur during a certain part of the day and most of the day all cells will be in bright sunlight.

Figure 2(d) shows the IV characteristic of a similar module (or segment), as that in Figure 2(a), but including a lower current cell with a high reverse breakdown. The lower current cell has short-circuit current Isc2. Where there is an external constraint (such as one or more further series-connected module) forcing Isc1 through the module, the whole module could be forced into reverse bias. In conventional modules, this is prevented by the inclusion of a "bypass diode" in anti-parallel with the module. If the module is driven into reverse bias, the bypass diode (which then becomes forward biased) turns on, and shunts the excess current. The reverse bias across the module is limited to the diode's forward bias Vf, and the lower-current cell does not reach Vbd. Thus, where the string current through the module forces it to operate at a high current Ist (shown at 61), then instead of the module operating at the reverse breakdown voltage of the lower-current cell (ie point B in the Figure), it operates at the by-pass diode's forward voltage (point A). (It will be appreciated that, as shown in Figure 2(d), the lower current cell may produce half the current of the fully illuminated cells. In this case, the excess current is equal to that through the lower current cell, and the current through the diode is equal to that through the lower current cell. In general, however, the diode is driven into forward voltage until its current corresponds to the excess current of the fully-illuminated cell over that of the lower current cell. Consequently, point A may be to the right or left of the position shown.)

Now, then, instead of *producing* the maximum possible power which could be available from this module (of approximately [n*Vmp2]*Imp2, shown at point C in Figure 2(d)), the module *consumes* a power of approximately Isc1*Vf, as shown at point A in Figure 2(d). This corresponds to a significant drop in efficiency for the photovoltaic system as a whole. Since, absent the bypass diode, the string module could otherwise be driven even further into reverse bias (shown at point B), it can be seen that the bypass diode thus protects the lower-current cell from potentially damaging high reverse bias, (the so-called "hot-spot" phenomenon), whilst at the same time it limits, but does not eliminate, the power loss in the system which results from the current mis-match.

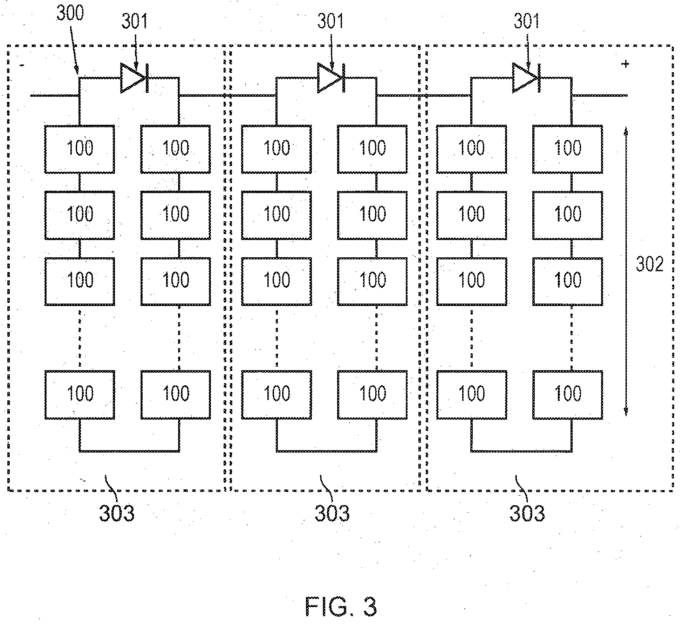

A conventional arrangement for a PV system is shown in Figure 3. A solar module 300 consists of perhaps 54-72 cells 100 in series, typically arranged in a meander-type fashion with a width 302 of 9-12 cells and one bypass diode 301 per segment of 18-24 cells. The number of cells per bypass diode is typically coupled to the breakdown voltage of the solar cells used. Segments 303 each comprising one group of solar cells and a bypass diode 301 are indicated as well. The 3 diodes in figure 3 are typically placed in a junction box (not shown) including a heat sink that is placed on the backside of each module.

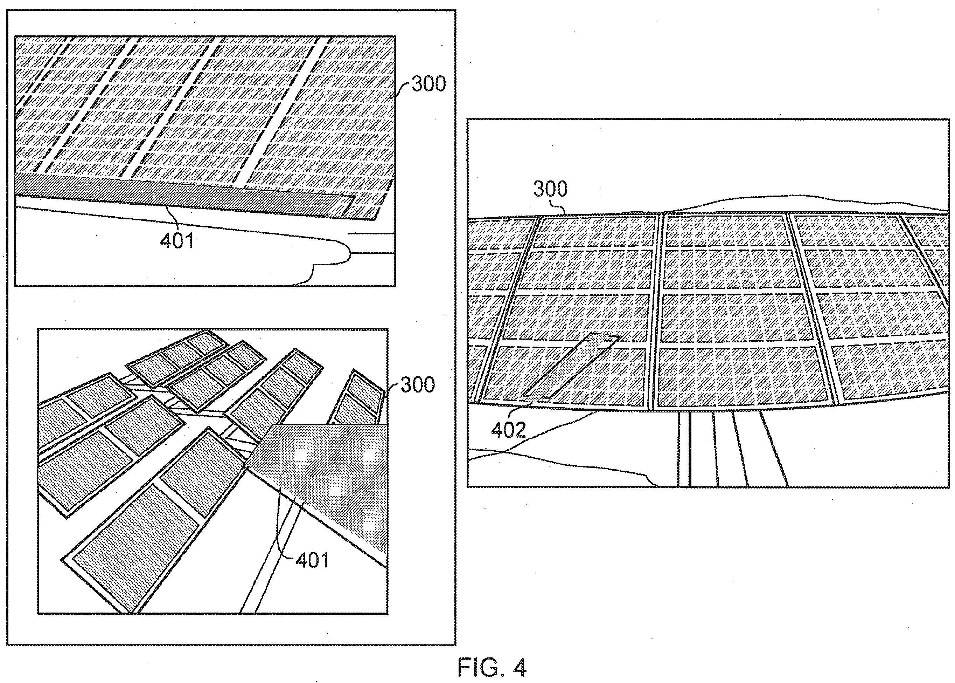

Some examples of modules 300, which are partially shadowed by other module shadows 401 or by antenna shadows 402, in practical PV systems are shown in Figure 4. As can be seen, only small portions of the modules therein are in the shade. As will be explained below, this will lead to a relatively large decrease in output power of the PV system in question.

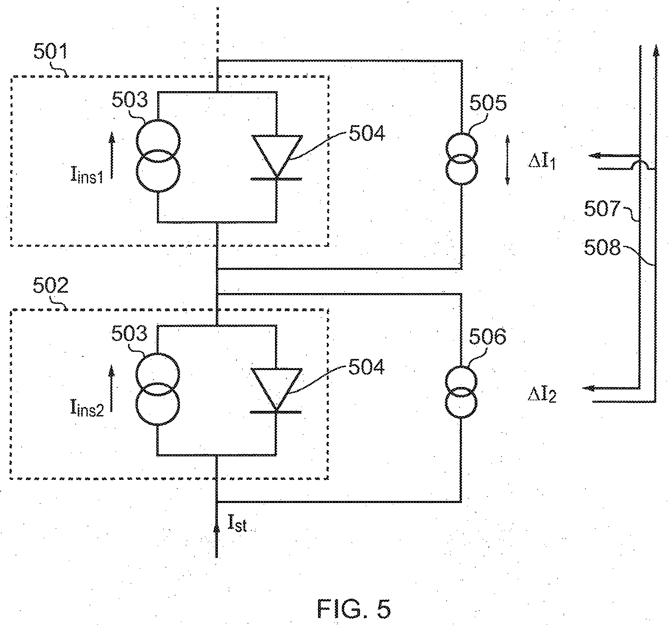

The above-described problem of output differences between PV modules in a PV system and the associated power drop is clearly recognized in the field. As described in IB2009/053001, various solution routes are available to deal with the problem of output-power decrease due to mismatch (hardware or insolation) between solar cells in a PV system. These solution routes include module-level DC-DC converters, string-level DC-DC converters and module-level DC/AC converters (micro inverters). A distinction can be made between 'sigma' module-level DC-DC converter concepts, where individual PV modules are connected to individual DC-DC converters that are in turn connected in series, and 'delta' DC-DC converters that can be placed per cell or group of cells. The 'delta' DC-DC converter was introduced in IB2009/053001 and its basic conception is shown in Figure 5, applied on solar-cell level. It should be noted that in general, the concept would not be implemented at the level of an individual solar cell, but at the level of groups of cells; however, the single cell example is useful in providing an understanding of the invention. Figure 5 shows 2 solar cells 501, 502, each depicted as a current generator 503 and diode 504. For simplicity, the series and shunt resistances are neglected. The cells produce respective currents $I_{ins1}$ and $I_{ins2}$, and are series-connected. Connected in parallel across the cells are supplementary power units 505 and 506 respectively. The supplementary power units, which are shown in this example as current generators, supply (or sink) additional currents $\Delta I1$ and $AI2$ respectively in parallel to the photo-generated currents $I_{ins1}$ and $I_{ins2}$. Thus, if Ist is the current through the string,

$$I_{ins1}+\Delta I1 = Ist,$$

and

$$I_{ins2}+\Delta I2 = Ist.$$

As shown by arrows 507 and 508, the current difference between each solar cell, and the string, is either replenished from a central source or fed back to the central source. As a result, the total energy obtained from the PV system is increased, relative to the case where the lowest cell current determines the power output from each of the cells.

As described in, IB2009/053001, the supplementary power units are conveniently and preferably provided in the form of the DC-DC converters. Because they only convert differences in powers (or currents) the converters may conveniently be termed "delta" converters.

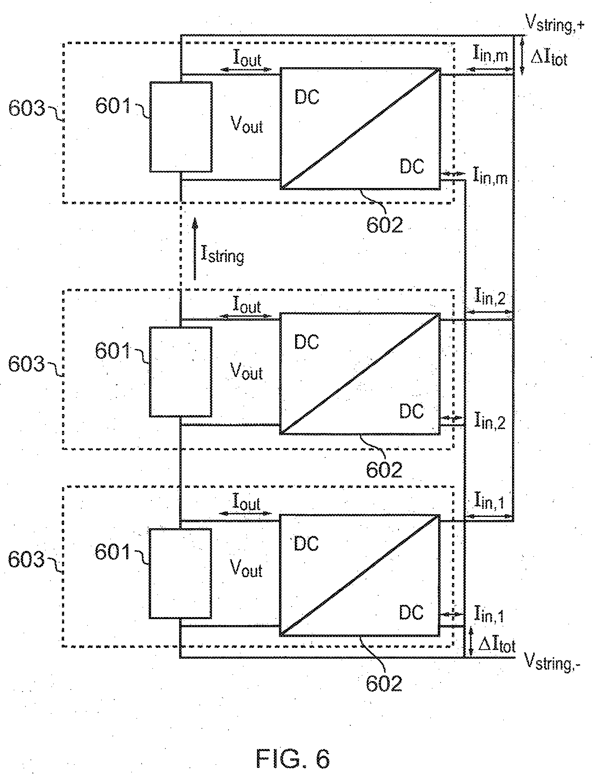

Figure 6 shows, in schematic form, a practical configuration of delta converters in a photovoltaic unit. The figure depicts a plurality of groups of cells 601, hereinafter also called the segments, which are series-connected. Connected in parallel across each group of cells 601 is a DC-DC converter 602, which acts as a current source. Each segment 601 and current source 602 form a sub-unit 603. Since the groups of solar cells themselves remain connected in series, this implies that the DC-DC converters implementing these current sources need to have both output nodes isolated from both input nodes. As shown in the figure, the delta converters are supplied by the string voltage. This implies that the positive inputs of the DC-DC converters are all connected to the positive string supply, whereas all the negative inputs are connected to the minus string supply. In the case that one of the DC-DC-converter output nodes is connected to one of the DC-DC-converter input nodes, such as would be the case for a non-isolated DC/DC converter, part of the string of modules or cells would be shorted.

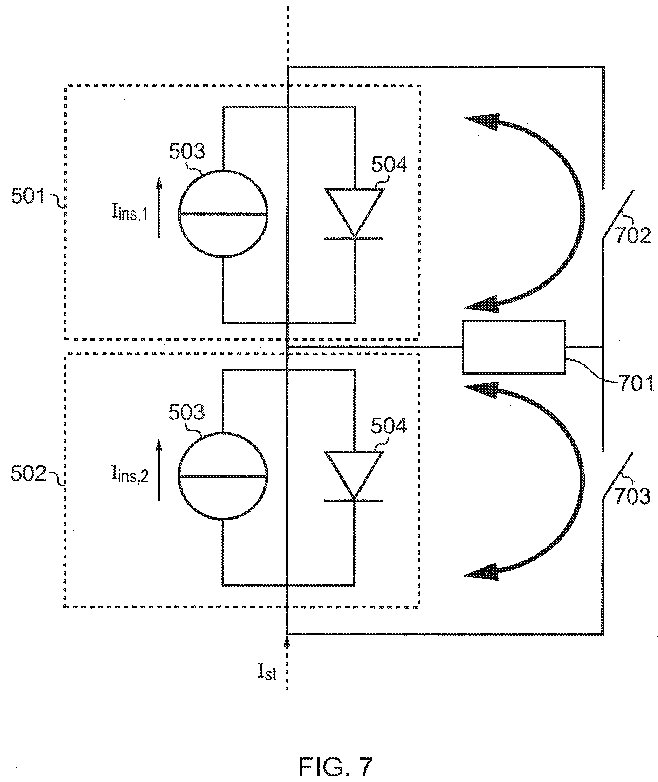

A photovoltaic unit according to an embodiment of the invention is shown in Figure 7. In the figure is shown two solar cells 501 and 502, each of which may be considered as a current source 503 in parallel with a diode 504. The photo-generated current from the cells is respectively $I_{ins1}$ and $I_{ins2}$. The cells are series-connected and form part of a string which carries string current Ist. Connected to the node between the two cells 501 and 502 is an energy storage element 701. The energy storage element 701 can be connected in parallel with either of the cells 501 and 502 by means of switches 702 and 703 respectively. The energy storage element 701 can be used to "harvest" energy (or, equivalently, power) from one solar cell and supplement the energy (power) provided by the other solar cell. In other words, energy is locally exchanged between neighbouring parts of the photovoltaic system. It should be noted that "energy exchange" will be used equivalently to "power exchange" herein, since the energy is merely the integral of the power, and, considered as an overall DC system, these may be treated as equivalent (over unit time).

The energy storage element 701 and switches 702 and 703 typically form a, or part of a, DC-DC converter. Further, in most practical embodiments of the individual solar cell 501 and 502 are replaced by a group of solar cells, as discussed with reference to figure 5.

Thus, as shown, the DC-DC, converter implementing the energy-exchange function is supplied by the two groups of cells around which it is arranged and not by the complete string or an intermediate voltage.

By locally exchanging energy between two neighbouring groups of cells the energy output of all groups of cells in a string are emulated to be equal. This effect is the same as that obtained by the solution discussed above with reference to figure 5. A difference, however, is that no isolated DC/DC converter is needed. Moreover, only low-voltage switches are needed and the control method is considerably simplified.

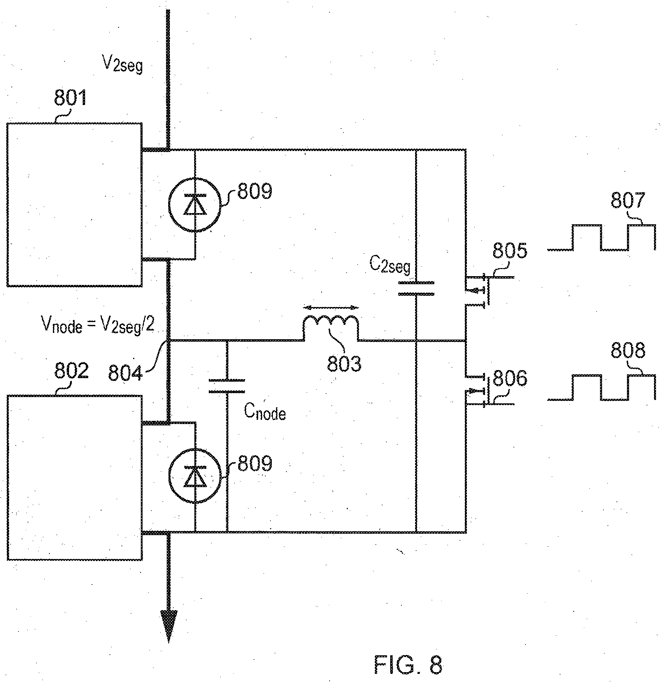

In figure 8 is shown one embodiment of the invention which provides a basic implementation of the concept schematically shown in figure 7. The figure shows two segments 801 and 802 each comprising a group of solar cells and which are connected in series. One end of an inductor 803 is connected to the node 804 between the two segments. The inductor 803 is connectable across the first segments by means of power switch 805, and connectable across the second segment by means of power switch 806. A first capacitor C2seg is connected across both segments, and a second capacitor Cnode is connected across the lower segment 802. In addition, by-pass diodes 809 are connected across each of the segments. This implementation thus comprises a half-bridge converter (although, in other embodiments, other known converters are also possible).

In operation, the power switches in the half bridge are controlled such that the node voltage $V_{node}$ between the two segments is half of the voltage $V_{2seg}$ across the two segments. As a result, the voltages across the two segments are effectively equalized. The DC-DC converter is implemented as a bi-directional converter. This implies that when e.g. the voltage across lower segment 802 is lower than the voltage across upper segment 801, the converter will act as a DC-DC down converter and will source current into the node in between the two segments. Effectively current is now fed from the upper segment 801 to the lower segment 802, enabling a higher output power of the two segments. The reason is that without the DC-DC converter, lower segment 803 would be bypassed because of its lower associated current level than upper segment 801. With the DC-DC converter, power from the upper segment 801 is used to supplement the current from segment 802, as a result of which both segments can again contribute to the output power of the string/PV system. In the case where e.g. the voltage across upper segment 801 is lower than the voltage across lower segment 802, the DC-DC converter will operate as up converter and will sink current out of the node in between the two segments and use this to supplement the current through segment 801. Effectively current is now fed from segment 802 to segment 801, again enabling higher output power of the two segments in series as described above. In both cases, energy is effectively exchanged between neighbouring segments, i.e. groups of an equal number of solar cells, as shown in Figure 7. In addition to the advantage of needing only lower-voltage switches, this implementation of a delta D-/DC converter achieves maximum power out of a string of series-connected segments without the need for complicated control schemes. Each segment DC-DC converter only needs to equalize the two segment voltages across which it is connected.

Due to the switched-mode operation of the half-bridge converter in either current direction, buffer capacitors are needed at the input and output of the converter. These capacitors have been added in the schematic of figure 8. The capacitors serve to keep the ripple voltages across $V_{node}$ and $V_{2seg}$ within reasonable limits. Note that ripple voltages on top of segment voltages lead to the segments being swept around their MPP. Therefore, the amount of ripple that is allowed depends on the desired total system efficiency. For simplicity, these capacitors have been left out of the more detailed embodiments further below. Due to the used voltage and power levels, the capacitance values will be relatively low, allowing the use of ceramic capacitors with relatively small volume.

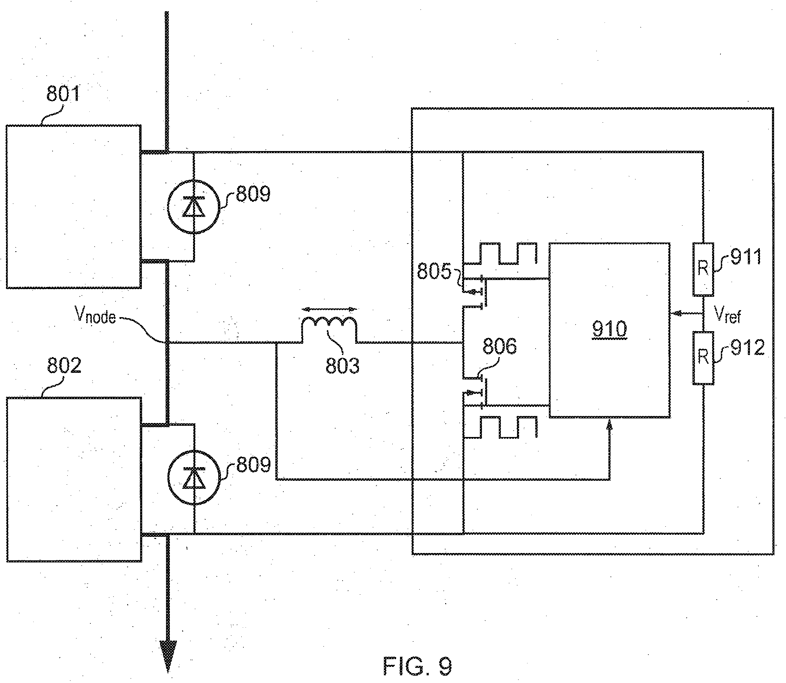

A more detailed embodiment of the half-bridge converter across two segments, including control means, is shown in figure 9. The basic arrangement is the same as that shown in figure 8 and the same reference numerals are used for the same components. A reference voltage $V_{ref}$ of half the voltage across two segments is derived, by a potential divider consisting of two resistors 911 and 912 having the same resistance R is used to control $V_{node}$. By feeding both the reference voltage $V_{ref}$ and the node voltage $V_{node}$ to the control block inside DC-DC-converter IC 910, the current into or out of the node can be controlled such that $V_{node}=V_{2seg}/2$. Note that in this embodiment the switches and control block have been integrated in one IC. A different partitioning, e.g. using external MOSFETs for the power switches, is also possible, depending on the required output power level of the DC-DC converter. The primary function is that the voltage at the node between two segments is controlled to half of the voltage of two segments in series, effectively equalizing both segment voltages.

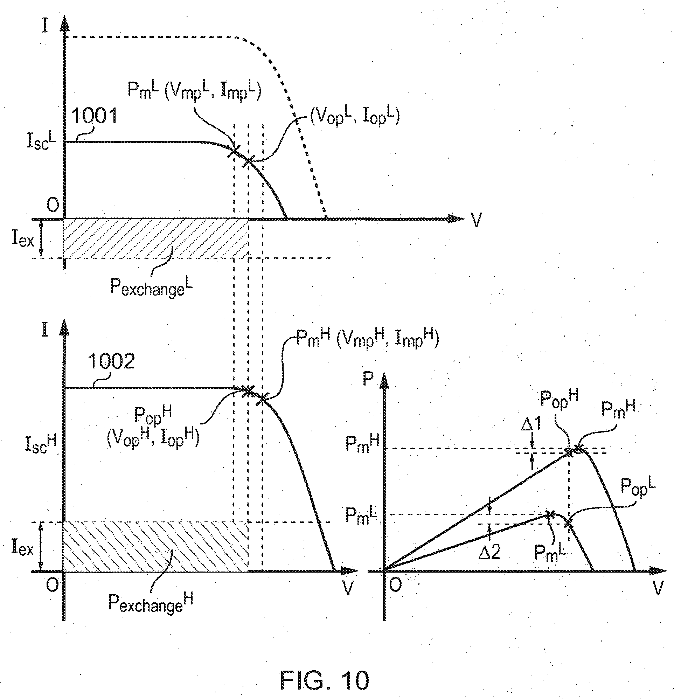

The effect of a DC-DC converter such as that shown in figure 9 on the operating characteristics of two segments, one of which is partially shaded, is shown in figure 10. Figure 10 shows the IV characteristics 1001 and 1002 of a partially shadowed (that is, shaded) segment having short-circuit current $I_{sc}^L$, and a fully illuminated (that is, lit) segment having short-circuit current $I_{sc}^H$. The lit segment has a maximum power point, providing power $P_m^H$ at a voltage $V_{mp}^H$ and current $I_{mp}^H$. Correspondingly, the shaded segment has a maximum power point providing power $P_m^L$ at the voltage $V_{mp}^L$ and current $I_{mp}^L$. Also shown are the corresponding power-voltage (PV) characteristics for the two segments, on which the respective maximum power points $P_m^H$ and $P_m^L$ are also depicted. As discussed above, operation of the DC-DC converter has the effect of adjusting the potential Vnode between the two segments to be half the combined voltage, that is to say the operating voltage of string 1001 adjusts to $V_{op}^H$ and the operating voltage of string at 1002 adjusts to $V_{op}^L$, and moreover $V_{op}^H = V_{op}^L$. Since the illumination conditions on each segment are unchanged, the respective IV characteristic is unchanged, and thus the operating point of each segment moves around its (unaltered) IV characteristic, to respective points ($V_{op}^H$, $I_{op}^H$) and ($V_{op}^L$, $I_{op}^L$), at which point they produce powers $P_{op}^H$ and $P_{op}^L$ respectively. Moreover, the operating point moves round each of the PV curves, to the left for the lit segment, and to the right for the shaded segment. As can be seen from the PV curves, the power output from the lit segment is lower than its maximum power by an amount $\Delta 1$, where $\Delta 1 = P_m^H - P_{op}^H$. Correspondingly, the power output from the shaded segment is lower than its maximum power by an amount $\Delta 2$, where $\Delta 2 = P_m^L - P_{op}^L$.

However, although each segment itself is now operating away from its optimum maximum power point, the effect is less marked on the sub-unit comprising the segment and the supplementary power (or current). This is shown in figure 10 by means of the hashed regions Pexchange$^H$ and Pexchange$^L$. The effective IV characteristic of the sub-unit, (rather than the segment itself), containing the lit segment corresponds to the bottom curve in figure 10, but with a translation of the voltage axis by an amount lex. The shaded region in the bottom curve having area Pexchange$^H$ = Iex * Vop$^H$, is equal to the power which is exchanged between the lit and shaded sub-units. Thus, provided that the DC-DC converter is 100% efficicient Pexchange$^H$ = Pexchange$^L$, where Pexchange$^L$ = Iex * Vop$^L$ and is the additional area produced under the operating point of the shaded segment by means of translating the voltage axis of the shaded segment downwards by an amount lex. Of course, for a non-ideal converter, which is less than 100% efficient, the ratio between Pexchange$^H$ and Pexchange$^L$ (or between Pexchange$^L$ and Pexchange$^H$ depending on the exchange direction) corresponds to the converter efficiency.

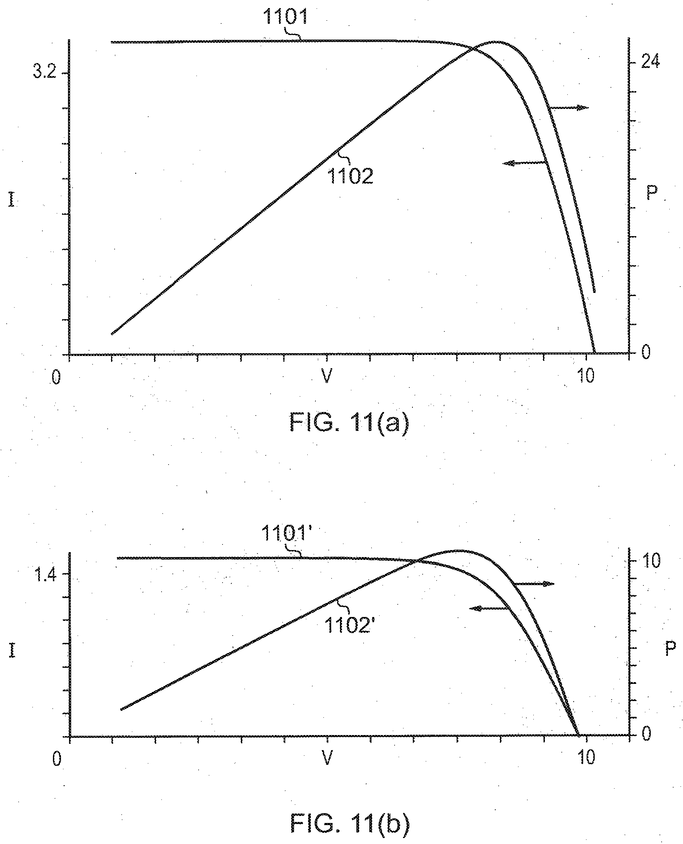

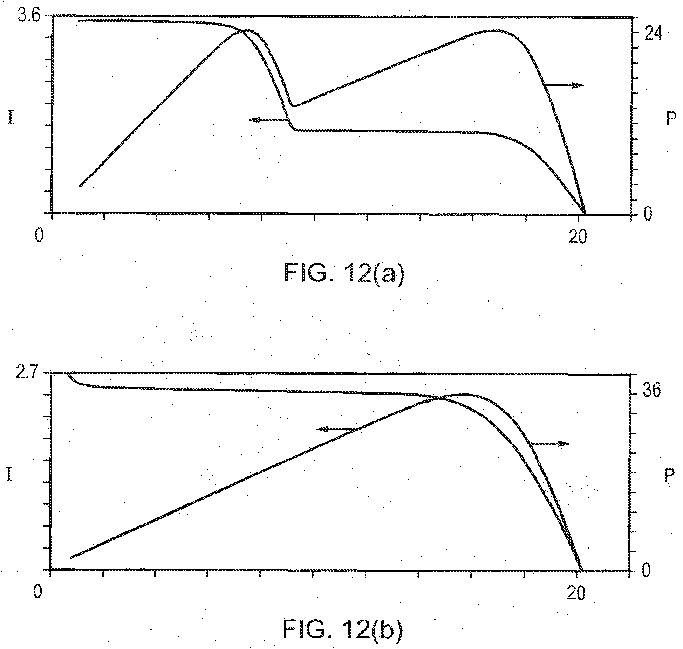

Figures 11 and 12 show simulated results for two segments, one being fully illuminated, (with illumination 700W/m$^2$), and the other partially shaded, at 300 W/m$^2$. They respectively have $P_m$=26.27W, $V_{mp}$=7.96V, and $I_{mp}$=3.30A, and $P_m$=10.77W, $V_{pm}$=7.77V and $I_{pm}$=1.39A, with IV and PV characteristics as shown at 1101, 1102 and 1101' and 1102' in Figure 11 a and 11(b) respectively.

When simulating the two segments in series, one with all cells at 700 W/m$^2$ and one with all cells at 300 W/m$^2$, and with the delta converter still inactive, the simulation result is as shown in Fig. 12(a). As expected, Fig. 12(a) shows two maximum points. The point on the right-hand side is where both segments are active at the max power current of the shaded (300 W/m$^2$) segment (~1.4 A). The point on the left-hand side, which is the highest of the two, occurs when the shaded segment is bypassed (mid-point voltage $V_{segment}$ is indeed -0.55 V at this point) and the lit segment operates at its maximum power current. The fact that the maximum power is slightly lower (24.46W here versus 26.27W in Fig. 11(a)) is caused by the additional losses in the bypass diode (0.55V* 3.28A=1.8W ; 26.27W-24.46W=1.8W).

The results of the simulation of operation with the delta converter active (with, as will be described below, almost zero voltage window and 100% efficiency; approaching ideal behaviour of a delta converter) is shown in Fig. 12(b). Due to the operation of the delta converter, there is now only one maximum power point remaining at 37 W. A closer inspection of the number reveals the following:

Firstly, consider current: the maximum power point current (for the combination) becomes 2.35A. The 'average' maximum power point current for the two segments is actually (3.30+1.39)/2=2.35A. So indeed, the delta converter ensures that the two sub-units 'act' as if they were irradiated with the average amount of light, leading to average current. And secondly, voltage: the maximum power point voltage becomes 15.75V and the midpoint voltage becomes 7.87V. Indeed 2*7.87V=15.74V, so as expected the delta converter makes the segment voltages equal. The MPP voltage per segment is therefore 7.87V. This voltage is indeed midway between the MPP voltage for 300 W/m$^2$ (7.77V) and that for 700 W/m$^2$ (7.96 V); (7.77+7.96)/2=7.87 V.

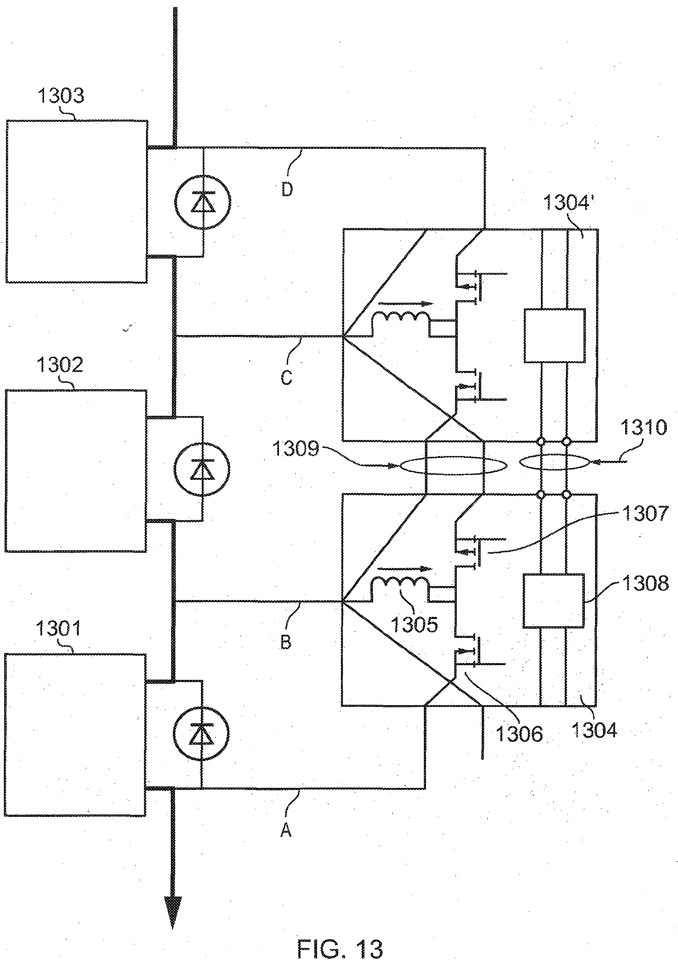

Most practical PV modules consist of 3 or 4 segments in series, each segment being equipped with one bypass diode. An example for 3 segments in a module was shown in Figure 13. To implement local energy exchange for more than 2 segments connected in series, connections need to be made between the DC-DC converters. This is schematically indicated in Figure 13 for 3 segments in series, as could be present inside one PV module. Three segments, at 1301, 1302 and 1303 are connected in series. An output from a supplementary power unit 1304, that is to say connections A and B, is connected in parallel with the first segment 1301. The input to the supplementary power unit 1304, that is to say connections A and C, is connected across two neighbouring segments 1301 and 1302. Similarly, an output from a second supplementary power unit 1304', that is to say connections B and C, is connected in parallel with the second segment 1302. The input to the supplementary power unit 1304', that is to say connections B and D, is connected across two neighbouring segments 1302 and 1303. Each supplementary power unit comprises a DC-DC converter, having an inductor 1305 connected between the output and the node between two switches 1306 and 1307, which together form a half-bridge circuit.

The DC-DC converter is under control of a control unit 1308.

Thus, each converter is connected to its own node voltage (in the case of converter 1304, to B) and the node voltages of the next higher (C in this case) and lower (A in this case) segments. Therefore, when each converter makes its own node voltage available to its neighbours, a simple two-wire power interface 1309 can accommodate the connections between the converters, as indicated in the figure. An additional communication interface 1310 is possible, e.g. for synchronization of the converters or for accommodating a central switch-off function. As indicated in the figure, this may also be accommodated by means of an additional e.g. 2-wire communication interface (in other embodiments, a one-wire communication interface may be used, or in still other embodiments, a wireless interface based on e.g. the Zigbee standard). In this case each converter should have a level shifter to shift the communication signals from the previous converter level to the next converters level. Level shifters are needed, since the node voltages will not be equal and will increase in the upward direction of the string depicted in the Figure 13. Note that since the DC-DC converters operate on node voltages in a string of segments, N=1 DC-DC converters are needed to accommodate a string of N segments in series. Finally, in normal operation, the bulk of the power (all power in case of no differences between groups of cells) is accommodated via the string. The connected DC-DC converters only operate on the power differences by exchanging chunks of energy between the sub-units or segment, in the appropriate direction and at the valid switching frequency of the converter.

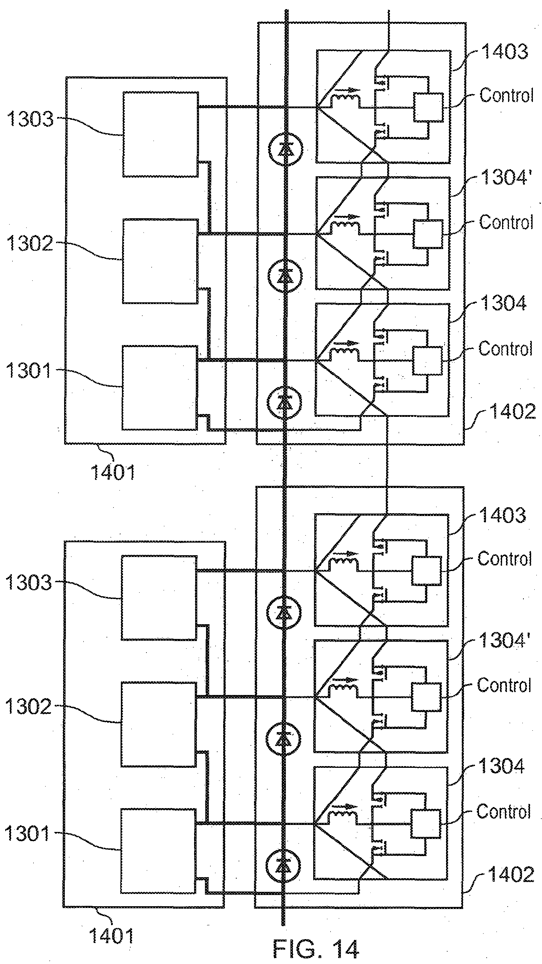

In cases where all segments inside a PV module are shaded or contaminated, all segments inside this PV module may be bypassed by their respective bypass diodes when other PV modules in the string generate enough power for the string to be installed at a string current at which they can operate at their maximum power point. In that case, connecting the converters in each PV module as shown in the previous embodiment would not suffice, since the voltages across each segment would be -$V_f$, where $V_f$ is the forward voltage across a bypass diode. Even in cases where all PV modules receive enough sun light for the DC-DC converters inside the PV modules to be active, differences between PV modules also need to be cancelled by exchanging energy between the PV modules to obtain maximum power from the string. To accommodate for this situation, one additional 'delta' half-bridge DC-DC converter may be added to each junction box of each PV module. This additional DC-DC converter can then be used to connect to a DC-DC converter in the junction box of the next PV module in the string. Such an embodiment is depicted in Figure 14. Figure 14 shows two PV modules 1401 connected in series, each comprising three series-connected segments 1301, 1302 and 1303. As in the embodiment of figure 13, segments 1301 and 1302 each have, in parallel therewith, an associated respective DC-DC converter 1304, 1304' acting as a supplementary power unit. However, the topmost segment 1303 of each module 1401 also now has an associated DC-DC converter 1403. The DC-DC converters for each module can conveniently be housed in a junction box 1402.

Note that as indicated, only one additional power wire now needs to be transported from the junction box of one PV module to that of another. As in the previous embodiment, only differences in power need to be transported across this additional power line. In state-of-the-art PV modules, the wiring occurs via the junction boxes, as indicated. This implies that in the embodiment of Figure 14, 4 wires come out of the junction box 1402, two connected on each side. For the top PV module in a string, the top DC-DC converter in the junction box will remain unconnected and is therefore redundant. As a result, in a string with N segments in total, N-1 DC-DC converters will be in use to exchange energy between all segments in the string.

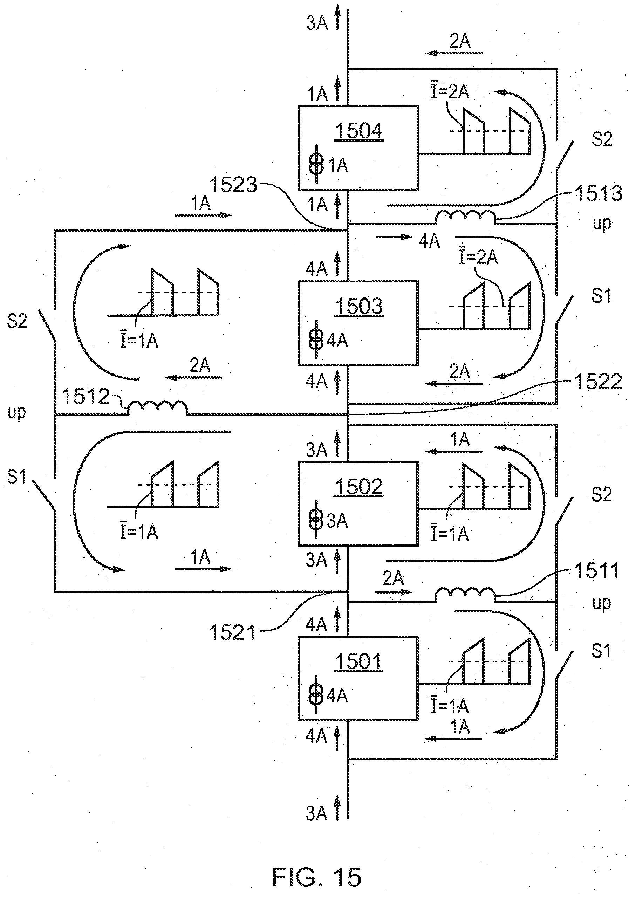

Operation of the DC-DC converters is illustrated in figure 15 for a simplified system. Figure 15 depicts a module comprising four series-connected segments 1501, 1502, 1503, and 1504. Associated with the lower three segments are DC-DC converters having respective inductors 1511, 1512 and 1513. As mentioned above, it can equally be considered that the DC-DC converters are associated with respective nodes 1521, 1522 and 1523, between a first 1501 and second 1502, second 1502 and third 1503, and third 1503 and fourth 1504 segments respectively. Each DC-DC converter includes two switches, a first switch S1, which is arranged to connect to the inductor across the lower segment, and a second switch S2 arranged to connect the inductor across the higher respective segment. In this exemplary, simplified, example, the segments are either fully illuminated or partially shaded such that the photo-generated currents in first to fourth segments are 4 A, 3A, 4A and 1A respectively. Assuming the segments all operate at the same voltage, and there is no overall power loss in the system, then the "average" string current will be 3A. As shown in the figure, the inductors 1511, 1512, and 1513 sink a current of 2A, 2A and 4A from the respective nodes. Each converter "redistributes" the current to the neighbouring nodes: thus the 2A sunk from node 1521 is redistributed - 1A sourced to the bottom end of the module, and 1A to node 1522; the 2A sunk from node 1522 is redistributed - 1A to node 1521 and 1A to node 1523, and the 4A sunk from node 1523 is redistributed - 2A to node 1522 and 2A to node the top end of the module. Finally, in the insert to each of the converter halves is shown schematically the current waveforms that are passing through that half of the converter. The time profile of the switched current is shown, along with the average current resulting.

Not shown in this simplified diagram are smoothing capacitors. These are needed, since the voltage ripple at both the input and output of the converter needs to be small to prevent the segments from cycling around their maximum power points. Therefore, input and output decoupling capacitors are preferred in all embodiments, as indicated in Fig. 8. In other words, voltage ripple at the input and output of the converters needs to be small, since the voltages at the segment terminals need to be DC, with only very small AC perturbations allowed. It will be appreciated that this requirement is no more onerous than that of known solutions without any DC-DC converters in place. Further, the inverter is also a switched-mode power supply with current ripple at the input (DC side) and therefore also in that case a sufficiently large input capacitor needs to be present. Of course, where there are multiple DC-DC converters, one capacitor may be placed across each segment. In that case, the capacitor $C_{2seg}$ shown in Fig. 8 is actually formed by two of the segment capacitors in series.

As shown in figure 15, all of the DC-DC converters are operating as up-converters (that is to say, the inductor sinks current from its node). It will be immediately apparent to the skilled person that in other configurations, it may be necessary for a converter to act as a down-converter, such that the inductor sources current into the node rather than sinks current from the mode. It will be equally apparent to the skilled person that a half-bridge converter as shown may be operable as either an up-converter or a down-converter, depending only on the control arrangement. In alternative, although less preferred, embodiments, an up-converter can be used in parallel with a down-converter for each DC-DC converter, only one (up or down) converter being active at any one time. Control of each converter may thus be simplified, at the expense of duplication of components such as inductors and switches.

Since the node voltage between two segments across which the half-bridge converter is present is controlled to half the voltage across the two segments in series, the duty cycle at which the DC-DC converter is operating is close to 50%, whether it is in up-conversion mode or in down-conversion mode. Because of this, an alternative embodiment, wherein the half-bridge converter is implemented as a dual-phase DC-DC converter with two parallel half bridges in anti-phase each with an individual coil, becomes attractive. This embodiment reduces the voltage ripple at both the input and output. This has a positive effect on the volume taken up by and the price of the passive components around the converter. First of all, the two coils in parallel will have the same volume as one coil in a single-phase implementation. The two capacitors, one at the input and one at the output of the dual-phase converter, will have an even smaller value and therefore volume and cost. The reason is that the ripple voltages at input and output become smaller and therefore capacitance values can be reduced to arrive at the same ripple voltage as for a single-phase implementation. Note that ripple cancellation between the two phases, operating at 180 phase difference, becomes optimum when the two phases operate at 50% duty cycle.

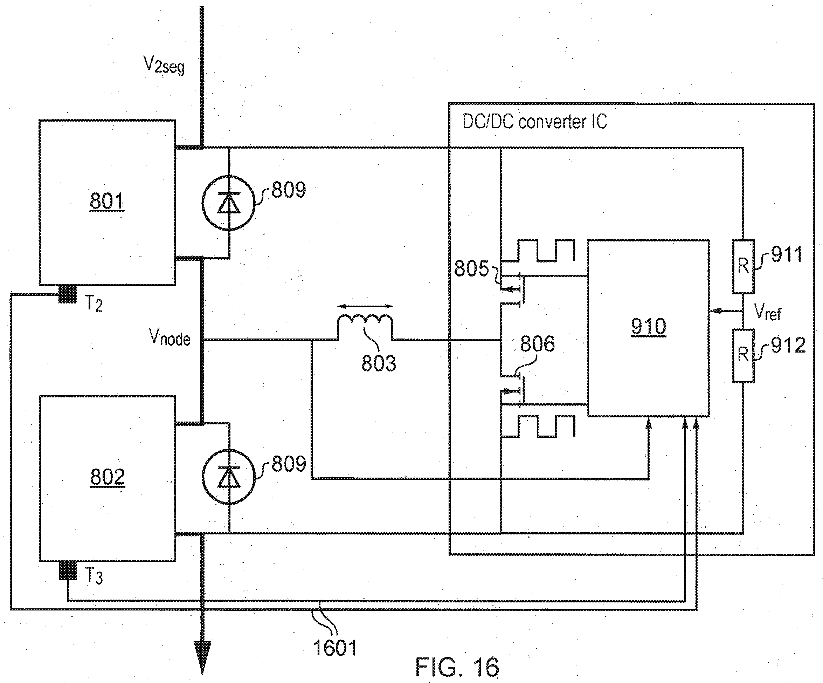

Since the operating characteristic of a segment, and in particular its operating voltage, depends on the temperature of the segments, in embodiments there can usefully be provided temperature sensing of the segments. Figure 16 shows a DC-DC converter connected across two segments, and including temperature sensing. The arrangement is similar to that shown in figure 9; however, in this embodiment temperature sensors T2 and T3 are attached to or placed in close proximity to segments 801 and 802; by means of temperature sensor lines 1601, information on the segments temperatures is fed back to the controller 910. The controller may then capable of adjusting the node voltage of the node to take into account differences in temperature of the panels.

Absent such a temperature sensing mechanism, when a temperature difference exists between the two segments across which the half-bridge converter is connected, the converter will try to compensate for this difference too. This is undesired, since the half-bridge converter should only compensate for differences in $I_{ins}$ between segments. The temperature differences are expected to remain limited in practice. However, the undesired behaviour may be prevented by taking the temperature difference between segments into account in the control block, as shown in figure 16. The DC-DC converters may now be switched off in case the temperature difference between the segments becomes too large. Alternatively, the control window installed around $V_{ref}$ may be shifted taking into account the diode variations as a function of temperature.

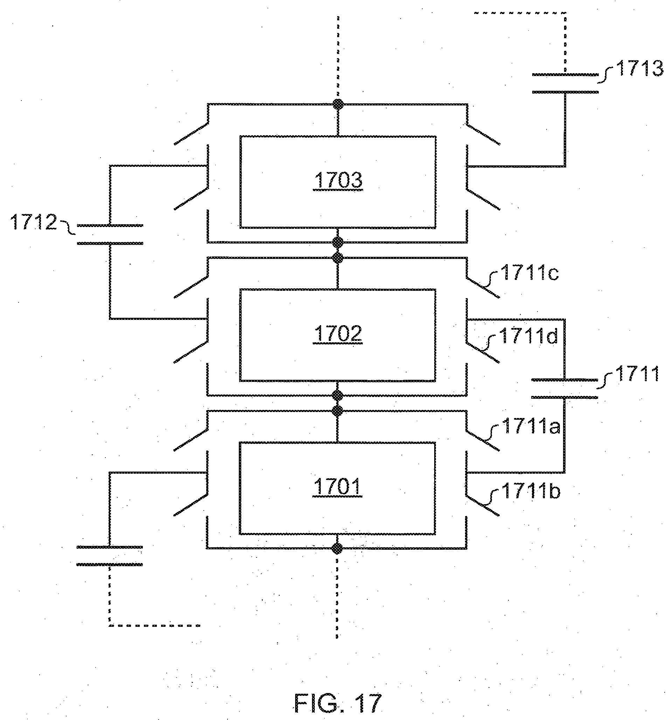

The embodiments described above have an inductor as the reactive element to store energy. However, voltage equalization between segments can also be effected using capacitive voltage converters. An example of such an embodiment is shown in Figure 17. Figure 17 shows schematically part of a module. Associated with series-connected segments 1701, 1702, 1703 *etc.* are capacitors 1711, 1712, *etc.* Either terminal of a capacitor is connectable to its associated node by mean of switches (1711a, 1711b), and a respective terminal is connectable to each neighbouring mode by means of switches (1711c, 1711d). By closing the switches in pairs (1711a, 1711c) and (1711b,1711d), the capacitors can first be connected in parallel to one segment with more energy, storing surplus energy in the capacitor, and then releasing it to the neighbouring segment by connecting it in parallel to that segment by means of closing the opposite pair of switches.

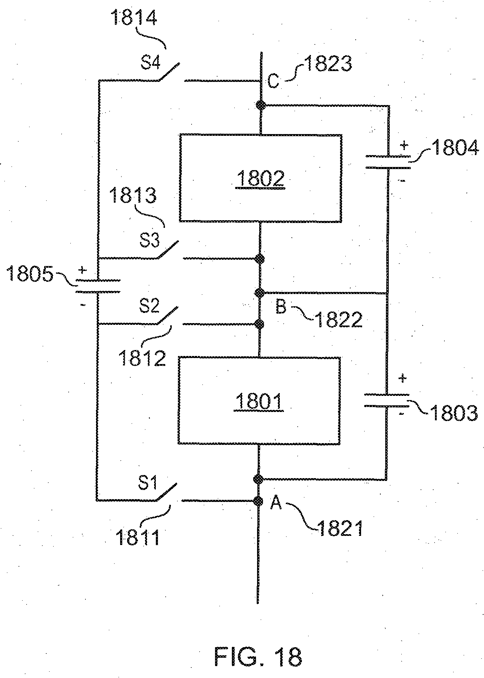

An example implementation for 2, segments is shown in Figure 18. The Figure shows two series-connected segments, 1801, and 1802, having outer nodes A 1821 and C 1823, and a centre node B 1822 therebetween. In parallel with the respective segments are capacitors 1803 (between A 1821 and B 1822) and 1804 (between B 1822 and C 1823), which act as buffer capacitors. A further capacitor 1805, which can act as either a buffer or a fly capacitor, is connected by means of switches S1 1811, S2 1812, S3 1813 and S4 1814. One terminal of capacitor 1805 is connectable to either the outer node A 1821 or the centre node B 1822, by means of switches S1 1811 and S2 1812 respectively. Similarly, the other terminal of capacitor 1805 is connectable to either the centre node B 1822 or the outer node C 1823, by means of switches S3 1813 and S4 1814 respectively. In operation, the switches are closed in pairs, that is, S1 1811 and S3 1813, followed by S2 1812 and S4 1814, with a 50% duty cycle. Other duty cycles are also possible, but a 50% duty cycle is easy to implement. This results in capacitor 1805 alternately being connected across segments 1801 and 1802, and thereby tending to equalise the voltage across the two segments. Cascading this arrangement, for more than two segments, results in the configuration shown schematically in Figure 17.

In order to avoid unnecessary power loss, in circumstances where the power consumption from the DC-DC converter is greater than the power which can be gained from balancing the sub-units - that is to say, where the DC-DC converter consumes more power than it saves - the DC-DC converter may be disabled or switched off. In practice, this is achieved by setting a voltage window around the mid-point voltage (V2seg/2), and disabling the converter, if the node between the sub-unit and the neighbouring sub-unit has a voltage within the voltage window. In embodiments in which separate DC-DC converters are used for up-conversion and down-conversion, such a window is important in order to ensure that the up- and down- converters are not operational at the same time. Moreover, provision of some hysteresis is useful to prevent bouncing between modes. Beneficially, disabling operation of the converter when it is within such a voltage window also assists in providing the control.

In summary, then, from one perspective, a photovoltaic unit is disclosed hereby, comprising a plurality of sub-units connected in series, each sub-unit having a main input and a main output, which main output is connected to the respective main input of a neighbouring sub-unit, each sub-unit further comprising a segment comprising one or more series-connected solar cells, and a supplementary power unit, wherein the supplementary power unit is configured to at least one of receive power from or supply power to the neighbouring sub-unit. The supplementary power unit is preferably a DC-DC converter, and arranged to exchange energy between neighbouring segments, without requiring a high-voltage connection across the complete string (of more than 2 segments). The converter may be inductive or capacitive. A DC-DC converter configured for use in such a unit is also disclosed, as is a method of controlling such a photovoltaic unit.

From reading the present disclosure, other variations and modifications will be apparent to the skilled person. Such variations and modifications may involve equivalent and other features which are already known in the art of photovoltaics, and which may be used instead of, or in addition to, features already described herein.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A photovoltaic unit comprising a plurality of sub-units connected in series, each sub-unit having a main input and a main output, which main output is connected to the respective main input of a neighbouring sub-unit, each sub-unit further comprising

   a segment (1301, 1302, 1303) comprising one or more series-connected solar cells, and a supplementary power unit (1304),
   wherein
   the supplementary power unit is configured to at least one of source current to and sink current from the main output of the respective neighbouring sub-unit,
   wherein the supplementary power unit comprises a DC-DC converter and has a first pair of terminals and a second pair of terminals, the first pair of terminals being connected one to each of the main input of the respective sub-unit and the main output of the neighbouring sub-unit, and the second pair of terminals (1309) being connected one to each of the main input of the respective sub-unit and the main output of the respective sub-unit,
   wherein the DC-DC converter comprises two series-connected switches (1306, 1307) connected between the first pair of terminals and having a half-bridge node therebetween, and an inductor (1305) connected between the half-bridge node and the main output of the respective sub-unit,
   wherein the supplementary power unit further comprises control means (1308) for controlling the series-connected switches,
   the control means comprising a communication interface (1310) to the neighbouring sub-unit.

2. A photovoltaic unit as claimed in claim 1, further comprising a capacitor (Cnode) connected between the main input and the main output of the respective sub-unit.

3. A photovoltaic unit as claimed in claim 1 or 2, wherein the control means is configured to control the switches such that the supplementary power unit operates as a half-bridge converter.

4. A photovoltaic unit as claimed in any preceding claim, wherein the control means further comprises a level shifter.

5. A photovoltaic unit as claimed in any preceding claim, wherein the supplementary power unit is disabled if the node between the sub-unit and the neighbouring sub-unit is within a predetermined voltage window around half the voltage between the input of the sub-unit and the output of the neighbouring sub-unit.

**Patentansprüche**

1. Eine Photovoltaik Einheit, welche aufweist
eine Mehrzahl von Unter-Einheiten, welche in Serie verbunden sind,
wobei jede Unter-Einheit einen Haupteingang und einen Hauptausgang hat,
wobei der Hauptausgang an den jeweiligen Haupteingang von einer benachbarten Unter-Einheit verbunden ist,
wobei jede Unter-Einheit ferner aufweist

ein Segment (1301, 1302, 1303), welches ein oder mehr Serien-verbundene Solarzellen und eine ergänzende Energie Einheit (1304) aufweist,
wobei

die ergänzende Energie Einheit zu zumindest einem konfiguriert ist von Strom liefern an den Hauptausgang von der jeweiligen benachbarten Unter-Einheit und Strom versenken von dem Hauptausgang von der jeweiligen benachbarten Unter-Einheit,

wobei die ergänzende Energie Einheit einen DC-DC Konverter aufweist und ein erstes Paar von Anschlüssen und ein zweites Paar von Anschlüssen hat,
wobei das erste Paar von Anschlüssen verbunden ist an jeweils einen von dem Haupteingang von der jeweiligen Unter-Einheit und dem Hauptausgang von der benachbarten Unter-Einheit, und
das zweite Paar von Anschlüssen (1309) verbunden ist an jeweils einen von dem Hauteingang von der jeweiligen Unter-Einheit und dem Hauptausgang von der jeweiligen Unter-Einheit,
wobei der DC-DC Konverter aufweist
zwei Serien-verbundene Schalter (1306, 1307), welche zwischen dem ersten Paar von Anschlüssen verbunden sind und einen Halbbrücken Knoten dazwischen haben, und
einen Induktor (1305), welcher zwischen dem Halbbrücken Knoten und dem Hauptausgang von der jeweiligen Unter-Einheit verbunden ist,
wobei die ergänzende Energie Einheit ferner ein Steuermittel (1308) aufweist zum Steuern der Serien-verbundenen Schalter,
wobei das Steuermittel ein Kommunikationsinterface (1310) zu der benachbarten Unter-Einheit aufweist.

2. Eine Photovoltaik Einheit gemäß Anspruch 1, ferner aufweisend einen Kondensator (Cnode), welcher zwischen dem Haupteingang und dem Hauptausgang von der jeweiligen Unter-Einheit verbunden ist.

3. Eine Photovoltaik Einheit gemäß Anspruch 1 oder 2, wobei das Steuermittel konfiguriert ist zum Steuern der Schalter, so dass die ergänzende Energie Einheit als ein Halbbrücken Konverter operiert.

4. Eine Photovoltaik Einheit gemäß einem beliebigen vorhergehenden Anspruch, wobei das Steuermittel ferner einen Pegelumsetzer aufweist.

5. Eine Photovoltaik Einheit gemäß einem beliebigen vorhergehenden Anspruch, wobei die ergänzende Energie Einheit blockiert wird, wenn der Knoten zwischen der Unter-Einheit und der benachbarten Unter-Einheit innerhalb eines vorbestimmten Spannungsfensters ist, welches etwa die halbe Spannung zwischen dem Eingang von der Unter-Einheit und dem Ausgang von der benachbarten Unter-Einheit ist.

**Revendications**

1. Unité photovoltaïque comprenant une pluralité de sous-unités connectées en série, chaque sous-unité ayant une entrée principale et une sortie principale, laquelle sortie principale est connectée à l'entrée principale respective d'une sous-unité avoisinante, chaque sous-unité comprenant en outre :

un segment (1301, 1302, 1303) comprenant une ou plusieurs cellules solaires connectées en série, et une unité d'alimentation supplémentaire (1304),
où
l'unité d'alimentation supplémentaire est configurée pour au moins un courant parmi un courant de source vers, et un courant absorbé par, la sortie principale de la sous-unité avoisinante respective,
où l'unité d'alimentation supplémentaire comprend un convertisseur DC-DC et a une première paire de bornes et une seconde paire de bornes, la première paire de bornes étant chacune connectée à chacune de l'entrée principale de la sous-unité respective et de la sortie principale de la sous-unité avoisinante, et la seconde paire de bornes (1309) étant chacune connectée à chacune de l'entrée principale de la sous-unité respective et de la sortie principale de la sous-unité respective,

où le convertisseur DC-DC comprend deux commutateurs connectés en série (1306, 1307) connectés entre la première paire de bornes et ayant un noeud en demi-pont entre eux, et un inducteur (1305) connecté entre le noeud en demi-pont et la sortie principale de la sous-unité respective,

où l'unité d'alimentation supplémentaire comprend en outre un moyen de commande (1308) pour commander les commutateurs connectés en série,

le moyen de commande comprenant une interface de communication (1310) avec la sous-unité avoisinante.

2. Unité photovoltaïque telle que revendiquée dans la revendication 1, comprenant en outre un condensateur (Cnode) connecté entre l'entrée principale et la sortie principale de la sous-unité respective.

3. Unité photovoltaïque telle que revendiquée dans la revendication 1 ou la revendication 2, dans laquelle le moyen de commande est configuré pour commander les commutateurs de sorte que l'unité d'alimentation supplémentaire fonctionne comme un convertisseur en demi-pont.

4. Unité photovoltaïque telle que revendiquée dans l'une quelconque des revendications précédentes, dans laquelle le moyen de commande comprend en outre un dispositif de décalage de niveau.

5. Unité photovoltaïque telle que revendiquée dans l'une quelconque des revendications précédentes, dans laquelle l'unité d'alimentation supplémentaire est désactivée si le noeud entre la sous-unité et la sous-unité avoisinante se situe dans une fenêtre de tension prédéterminée autour de la moitié de la tension entre l'entrée de la sous-unité et la sortie de la sous-unité avoisinante.

FIG. 1(a)

FIG. 1(b)

$$FF = \frac{\square}{\square + \diagdown + \triangle}$$

$$\eta \simeq \frac{P_m}{\Phi.A} = \frac{FF.Isc.Voc}{\Phi A.}$$

FIG. 1(c)

FIG. 1(d)

$\times n \Rightarrow$

FIG. 2(a)

$\times (n-1) + \Rightarrow$

$V_{bd}$

$(n-1)V_{oc}^{1} + V_{oc}^{2}$

FIG. 2(b)

FIG. 2(c)

FIG. 2(d)

FIG. 3

EP 2 280 469 B1

FIG. 4

EP 2 280 469 B1

FIG. 5

FIG. 6

FIG. 7

FIG. 8

FIG. 9

FIG. 10

FIG. 11(a)

FIG. 11(b)

FIG. 12(a)

FIG. 12(b)

FIG. 13

FIG. 14

FIG. 15

FIG. 16

FIG. 17

FIG. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009053001 A
- DE 10219956
- US 20051392658 A
- EP 1081824 A